# EUROPÄISCHE PATENTSCHRIFT

(11) **EP 2 549 536 B1**
(45) Veröffentlichungstag und Bekanntmachung des Hinweises auf die Patenterteilung: **19.08.2020**
(21) Anmeldenummer: 11006012.6
(22) Anmeldetag: 22.07.2011
(51) Int. Cl.: H01L 27/146

(54) **Halbleiterstruktur zur Photonendetektion**
Semiconductor structure for photon detection
Structure semi-conductrice pour la détection de photons

(43) Veröffentlichungstag der Anmeldung: 23.01.2013
(60) Teilanmeldung: 19213586.1
(73) Patentinhaber: Espros Photonics AG, 7320 Sargans (CH)
(72) Erfinder: Popp, Martin, 7000 Chur (CH); De Coi, Beat, 7320 Sargans (CH); Annese, Marco, 7000 Chur (CH)
(74) Vertreter: Otten, Roth, Dobler & Partner mbB Patentanwälte

(56) Entgegenhaltungen:
- EP-A2- 1 995 783
- WO-A1-2010/053881
- JP-A- 2005 150 521
- US-A1- 2008 265 295
- US-A1- 2010 014 675
- GROOM D E ET AL: "Back-illuminated, fully-depleted CCD image sensors for use in optical and near-IR astronomy", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 442, Nr. 1-3, 1. März 2000 (2000-03-01), Seiten 216-222, XP004193493, ISSN: 0168-9002, DOI: 10.1016/S0168-9002(99)01224-3
- Senthil Theppakuttai: "Probing Assessment on Fine Pitch Copper Pillar Solder Bumps", IEEE SW Test Workshop, 1 June 2010 (2010-06-01), pages 1-26, XP055054128, San Diego, CA, USA

## Beschreibung

Die Erfindung betrifft eine Halbleiterstruktur zur Photonendetektion nach dem Oberbegriff des Anspruchs 1.

Aus dem Stand der Technik ist beispielsweise durch die US 5,786,609 A ein Halbleiterdetektor bekannt, welcher eine Unipolarstruktur aufweist, sowie eine als Schicht an der Unterseite ausgebildete "Return-Elektrode", die zum Abzug der Leitungsträger aus der Verarmungszone ausgebildet ist. Aus der WO 2010 / 053881 A1 ist ein Photodioden-Array bekannt, bei dem die elektrischen Kontakte zu den Dioden u.a. durch das Substrat hergestellt sind.

Aufgabe der Erfindung ist es, eine Halbleiterstruktur zur Photonendetektion zur Verfügung zu stellen, welche eine Kostenersparnis bei der Produktion ermöglicht.

Diese Aufgabe wird, ausgehend von einer Halbleiterstruktur der eingangs genannten Art, durch die kennzeichnenden Merkmale des Anspruchs 1 gelöst.

Durch die in den abhängigen Ansprüchen genannten Maßnahmen sind vorteilhafte Weiterbildungen und Ausführungen der Erfindung möglich.

Dementsprechend zeichnet sich eine erfindungsgemäße Halbleiterstruktur zur Photonendetektion, umfassend: ein Substrat aus einem Halbleitermaterial mit einer ersten Dotierung, einen Kontaktbereich, der an der Vorderseite des Substrates angebracht ist, eine Bias-Schicht aus einem Halbleitermaterial mit einer zweiten Dotierung, welche auf der Rückseite des Substrats beabstandet vom Kontaktbereich angeordnet ist, wobei der Kontaktbereich wenigstens teilweise der Bias-Schicht gegenüberliegt, so dass in lateraler Richtung ein Überlappbereich vorhanden ist, ein Guardring, der auf der Vorderseite des Substrats angeordnet ist und den Kontaktbereich umgibt, wobei zwischen dem Kontaktbereich und dem Guardring eine Sperrspannung anlegbar ist, dadurch aus, dass der Überlappbereich eine laterale Ausdehnung aufweist, die wenigstens ein Viertel der Distanz zwischen dem Kontaktbereich und der Bias-Schicht beträgt.

Der Guardring ist eine Art Schutzstruktur, welche durch das an ihn angelegte Potential den Kontaktbereich von dessen Umgebung bzw. von weiteren Halbleiterstrukturen abschirmen kann. Unter anderem können insbesondere auch vagabundierende Ladungsträger abgefangen werden; es wird auch ermöglicht, die parasitären Widerstände zu senken.

Bei der erfindungsgemäßen Halbleiterstrurktur ermöglicht der Guardring, dass seitlich des Guardrings eine Verarmung erfolgt, d.h. es kann eine Verarmungszone gebildet werden, sodass der Kontaktbereich von übrigen Bereichen wie gegebenenfalls CMOS-Strukturen bzw. Sensorstrukturen abgeschirmt ist.

Wenn der Kontaktbereich beispielsweise lediglich dadurch gebildet wird, dass ein Metallkontakt auf das Substrat aufgebracht wird, kann die Distanz zwischen dem Kontaktbereich und der Bias-Schicht der Dicke des Substrates entsprechen.

Die Bias-Schicht ist dementsprechend auf der Rückseite des Substrats ausgebildet. Der Überlappbereich im Sinne der Erfindung ist der Bereich, in dem der Kontaktbereich in lateraler Ausdehnung sich über der Bias-Schicht erstreckt.

Die Halbleiterstruktur kann vorzugsweise als Photodetektor eingesetzt werden. Insbesondere kann sie als Photodetektor für den Infrarotbereich dienen. Die Bias-Schicht auf der Rückseite kann dazu dienen, zwischen Bereichen auf der Vorderseite mit einer Dotierung erster Art (Substratkontakt)und der Bias-Schicht eine Verarmungszone herzustellen (engl.: depletion zone). Wird durch die Absorption eines Photons in dieser Verarmungszone ein Elektron-Loch-Paar erzeugt, so werden diese aufgrund des elektrischen Feldes in der Verarmungszone getrennt. Insbesondere können die Elektronen im Substratkontakt auf der Vorderseite des Substrats nachgewiesen werden.

Insbesondere kann durch die erfindungsgemäße Halbleiterstruktur eine Kostenersparnis dadurch erreicht werden, dass die Bias-Schicht auf der Rückseite nicht eigens kontaktiert wird. Üblicherweise wird für eine solche Kontaktierung dieser Schicht auf der Rückseite, die bei handelsüblichen Halbleiterstrukturen insbesondere aus Metall ausgebildet sein kann, ein Draht aufgebondet oder eine Kontaktierung durch das Siliziummaterial (engl.: throughsilicon via, Abk.: TSV) hergestellt. Diese Fertigung kann jedoch zu hohen Kosten führen. Eine derartige Kontaktierung kann jedoch bei der erfindungsgemäßen Halbleiterstruktur vermieden werden. Aufgrund der Maßnahme, dass die minimale Lateralausdehnung, durch welche der Überlappbereich gebildet wird, größer ist als ein Viertel der Substratdicke bzw. der Distanz zwischen dem Kontaktbereich und der Bias-Schicht auf der Rückseite beträgt, kann eine Beeinflussung der Bias-Schicht erfolgen.

Grundsätzlich wird bei der Fertigung einer derartigen Halbleiterstruktur regelmäßig ein Halbleitermaterial für das entsprechende Substrat verwendet (z.B. Germanium oder Silizium), während in unterschiedlichen Bereichen die Dotierung beim Herstellungsprozess anders ausgebildet werden kann, etwa eine stärkere oder schwächere Dotierung sowie eine gleichnamige oder ungleichnamige Dotierung.

Ein weiterer grundsätzlicher Vorteil der erfindungsgemäßen Halbleiterstruktur besteht darin, dass bei der Halbleiterfertigung, etwa in einer Prozessstraße die Bearbeitung der Rückseite reduziert werden kann. Ein weiterer Vorteil der erfindungsgemäßen Halbleiterstruktur zur Photonendetektion besteht darin, dass mit verringerten Spannungen gearbeitet werden kann, um eine entsprechende, ausreichende Verarmungszone zur Detektion erhalten zu können.

Erfindungsgemäß ist der Kontaktbereich dazu ausgebildet, dass durch das an ihn angelegte Potential das Potential der Bias-Schicht beeinflusst wird. Der Kontaktbereich selbst wird durch einen Guardring, der ebenfalls auf der Vorderseite des Substrats angeordnet ist, umgeben und von diesem abgeschirmt. Die Sperrspannung selbst wird gleichzeitig zwischen dem Kontaktbereich und dem Guardring angelegt, das heißt, ein Pol der entsprechenden Spannung wird am Kontaktbereich angelegt, der andere am Guardring. Die Polung der Spannung hängt unter anderem davon ab, welche Dotierung das Substrat bzw. das übrige Halbleitermaterial aufweist. Würde die Lateralausdehnung kleiner als ein Viertel der Dicke des Substrats gewählt, so würde das Potential im Bereich des Bulkmaterials des Substrats zwischen dem Kontaktbereich und der Bias-Schicht auf der Rückseite im Wesentlichen durch die Guardring-Spannung beeinflusst. Dadurch allerdings, dass die Lateralausdehnung größer als ein Viertel der Dicke gewählt wird, also in die Größenordnung der Substratdicke gelangt, wird das Potential mit zunehmender Lateralausdehnung immer mehr unabhängig von der Guardring-Spannung. Schließlich wird nicht nur das Potential im Bulkmaterial durch das am Kontaktbereich angelegte Potential beeinflusst, sondern ebenfalls das Potential der Bias-Schicht. Es entsteht ein Potentialkanal, ein Leitungskanal zwischen dem Kontaktbereich und der gegenüberliegenden Bias-Schicht.

Der Kontaktbereich kann durch eine metallische Kontaktierung auf der Substratoberfläche gebildet sein. Ferner kann der Kontaktbereich allerdings auch eine im Substrat ausgebildete Wanne umfassen. Diese wird dementsprechend ungleichnamig im Vergleich zur ersten Dotierung, also im Vergleich zum Substrat dotiert. Dadurch wird auch ermöglicht, dass der Kontaktbereich, der als Wanne ausgebildet ist, tiefer in das Substrat hineinreicht und somit zum Beispiel das Potential der Bias-Schicht noch stärker beeinflussen kann.

Insbesondere ist es möglich, das Halbleitermaterial mit der Dotierung erster Art, d. h. insbesondere das Substrat, bei einer Ausführungsform der Erfindung schwach zu dotieren, es also hochohmig auszubilden. Dieses Material ist insbesondere vorteilhaft für die Photonendetektion, das heißt, für die Ladungsträgertrennung bei der Photonenabsorption.

Ferner ist bei der Erfindung die Dotierung zweiter Art im Vergleich zur Dotierung erster Art ungleichnamig dotiert. Durch Anlegen einer entsprechenden Sperrspannung wird eine Beeinflussung der Bias-Schicht dadurch erreicht, dass die Majoritätsladungsträger durch das Potential abgezogen werden. Somit erfolgt die Ausbildung einer Diode. Die Bias-Schicht ist dabei im Vergleich zum Substrat ungleichnamig dotiert.

Der Guardring wiederum weist erfindungsgemäß eine gleichnamige Dotierung wie das Substrat, d. h. das Halbleitermaterial mit Dotierung erster Art, auf. Durch die Kontaktierung mit der Sperrspannung werden wiederum die Majoritätsladungsträger des Guardrings abgezogen.

Ferner kann bei einer Ausführungsform der Erfindung der Guardring stärker dotiert sein als das Substrat. Diese stärkere Dotierung ermöglicht eine besondere Abschirmungsfunktion, welche der Guardring hinsichtlich des Kontaktbereichs gegenüber den übrigen Bereichen ausüben soll.

Erfindungsgemäß wird die Halbleiterstruktur so ausgebildet, dass sie von der Rückseite beleuchtet werden kann. Diese Rückseitenbeleuchtung ermöglicht zum einen, dass Photonen in möglichst vorteilhafter Weise in den Bereich der Verarmungszone eindringen können. Da es zudem vermieden wird, die Rückseite zu kontaktieren, oder diese mit weiteren Bauteilen zu bestücken, kann das Licht umso ungehinderter in das Substrat eindringen, da keine störenden Kontakte usw. auf dem Weg des Lichtes im Wege sind. Damit kann unter anderem auch die Effizienz der Halbleiterstruktur bei der Photonendetektion gesteigert werden.

Bei einer weiteren Ausführungsform der Erfindung kann lateral versetzt zum Kontaktbereich wenigstens ein weiterer Bereich angeordnet sein, der wenigstens eine Wanne aus einem gleichnamig dotierten Material wie der Kontaktbereich umfasst. Insbesondere kann wenigstens ein weiterer Bereich als Sensorbauteil zur Detektion, insbesondere zur Detektion von Photonen ausgebildet sein. Da diese Bereiche lateral versetzt zum Kontaktbereich angeordnet sind, das heißt, sich auf der Vorderseite der Halbleiterstruktur befinden, sind diese gegebenenfalls bei einer Rückseitenbeleuchtung dem Licht nicht im Wege, so dass eine höhere Photonenausbeute erreicht werden kann.

Zudem kann aber auch ein Bereich als Verarmungszone und somit zur Photonendetektion genutzt werden, welcher lateral versetzt ist zum Bereich unterhalb des Kontaktbereiches. Auch dieser Teil des Bulkmaterials wird somit als Absorptionsbereich genutzt und wird zur Verarmungszone.

Bei einer vorteilhaften Ausbildungsform der Erfindung wird der Absorptionsbereich bei Anliegen der Sperrspannung zur Verarmungszone.

Bei einer bevorzugten Weiterbildung der Erfindung wird das Substrat der Halbleiterstruktur aus im Zonenziehverfahren gewonnenen Silizium gefertigt (engl.: float-zone silicon). Dieses Material zeichnet sich durch sehr geringe Störstellen und durch besondere Homogenität aus. Die Leitfähigkeit liegt bei mehreren hundert Ohm x Zentimeter (Ω cm) bis zu mehreren kQ cm.

Insbesondere ist das Halbleitermaterial mit Dotierung erster Art bzw. das Substrat bei einer Weiterbildung der Erfindung schwach n-dotiert. Eine dementsprechend schwache Dotierung führt zu einem hohen Widerstand des Materials und zu einer geringen Dichte an Majoritätsladungsträgern.

Bei einer vorteilhaften Ausführungsform der Erfindung ist zwischen dem Kontaktbereich und dem Guardring bzw. dem Kontaktbereich und dem wenigstens einen weiteren Bereich teilweise eine Grabenisolation (engl.: shallow-trench isolation, Abkürzung: STI) angeordnet. Eine entsprechende Isolation führt zu einer weiteren Abschottung im Hinblick auf das entsprechende Potential, sofern dies notwendig ist.

Ein besonderer Vorteil der erfindungsgemäßen Halbleiterstruktur ist es, eine besonders gute Quantenausbeute, insbesondere im nahen Infrarotbereich erzielen zu können. Dazu ist es regelmäßig notwendig, eine entsprechend ausgedehnte Verarmungszone in der Größenordnung einiger Mikrometer (µm) zur Verfügung zu stellen, da die Absorptionslänge im Siliziummaterial zwischen 4 µm bei einer Wellenlänge des Lichts von 750 nm bis zu 200 µm bei 1000 nm Wellenlänge beträgt. Bei handelsüblichen Photodioden wird dies durch eine so genannte pin-Struktur (engl. Abk. für: positive - intrinsic - negative) erreicht. Im Falle von Photodetektoren mit integrierter Detektionselektronik ist dieser Ansatz jedoch ungeeignet. Die Ausdehnung der Verarmungszone im Substrat wird hauptsächlich beeinflusst durch die Dotierung innerhalb des Substrats. Ferner ist zu beachten, dass die Sperrspannung, welche an der Vorderseite angelegt werden kann, begrenzt ist und typischerweise in der Größenordnung von wenigen Volt liegt.

Derartige Photodetektoren besitzen den Nachteil, dass die Absorptionslänge wesentlich größer sein kann als die Ausdehnung der Verarmungszone. Dementsprechend kann es vorkommen, dass eine große Anzahl an erzeugten Ladungsträgern bei der Photonenabsorption außerhalb der Verarmungszone im Bulkmaterial entsteht. Dort haben die Minoritätsladungsträger nur eine kurze Lebenszeit und sind keinem elektrischen Feld ausgesetzt, so dass nach Aufspaltung der Ladungsträger diese nicht rasch genug voneinander getrennt werden können und wieder rekombinieren. Aufgrund dieses Rekombinationseffektes, der dann entsteht, wenn das entsprechende elektrische Feld nicht hoch genug ist, um eine ausreichende Trennung der Ladungsträger beizubehalten bzw. einen schnellen, der Rekombination entgegen wirkenden Abzug von Ladungsträgern zu ermöglichen, wird ein entsprechender Teil der aufgespaltenen Ladungsträger wieder rekombinieren und geht somit für die Detektion verloren. Ein anderer Teil der erzeugten Ladungsträger unterliegt einer lateralen Diffusion aufgrund des fehlenden elektrischen Feldes und wird somit schließlich an einer anderen Stelle detektiert, nämlich nicht dort, wo es entsprechende Photonen, das zur Auftrennung der Ladungsträger geführt hat, tatsächlich absorbiert worden ist (engl.: image blue). Im Übrigen läuft ein entsprechender Diffusionsprozess der Ladungsträger grundsätzlich vergleichsweise langsam ab, so dass die entsprechende Zeitkorrelation bei der Detektion verloren gehen kann, weil die entsprechenden Ladungsträger nur langsam wegdiffundieren und somit zwischen der Trennung der Ladungsträger und der eigentlichen Detektion eine entsprechende Zeit vergeht. Diese beschriebenen Nachteile können durch die erfindungsgemäße Halbleiterstruktur vermieden bzw. reduziert werden. Durch die Bereitstellung eines Substrates mit entsprechend schwacher Dotierung kann erreicht werden, dass die Verarmungszone eine entsprechende Ausdehnung besitzt.

Wie bereits oben erwähnt wurde, kann auf der Vorderseite eine entsprechende Elektronik zur Detektion aufgebracht werden. Hierbei kann es sich um typische CMOS-Strukturen handeln. Es ist besonders vorteilhaft, diese Strukturen entsprechend abzuschirmen, insbesondere durch einen Guardring, welcher den Kontaktbereich umgibt. Dieser Guardring wird auch zum Anlegen der Sperrspannung genutzt. Die entsprechende Abschirmung bewirkt auch eine Abschirmung von Rauschen oder von zusätzlichen Effekten durch die Kontaktierung des Kontaktbereiches in Bezug auf etwaige Kontaktierungen der weiteren Bereiche, beispielsweise der CMOS-Strukturen. Eine Verarmungszone kann praktisch im gesamten Bulkmaterial erzeugt werden.

Um die Ausbildung einer Verarmungszone bzw. eines entsprechenden Leitungskanals unterhalb des Kontaktbereiches zu erleichtern, ist eine Bias-Schicht auf der Rückseite angebracht, die ungleichnamig dotiert ist in Bezug auf das Halbleitermaterial mit Dotierung erster Art, also das Halbleitermaterial des Substrats. Ist das Halbleitermaterial mit Dotierung erster Art beispielsweise schwach n-dotiert, so wird die Bias-Schicht p-dotiert. Diese Kontaktierung der Bias-Schicht wird durch die erfindungsgemäße Halbleiterstruktur jedoch vermieden.

Insbesondere können vorteilhafterweise herkömmliche Prozessstraßen zur Waferproduktion verwendet werden, die eine Fertigung der Vorderseite ermöglichen (Engl.: frontside processing), ein Abdünnen des Wafers (Engl.: wafer thinning) sowie eine etwaige Bearbeitung der Rückseite (Engl.: backside processing). Das so genannte "frontside processing" kann dabei nach handelsüblicher Art und Weise durch Fertigung von Dotierungen, beispielsweise durch Ionenimplantation, Oxidationsprozesse, Metallisierungen, STI, Passivierungen usw. erfolgen. Dadurch können Widerstände, Transistoren usw. aufgebaut werden. Durch die Fertigung aktiver Strukturen sowie so genannter STI's können verschiedene Bereiche ausgebildet werden. Der Kontaktbereich wiederum wird durch einen Guardring von diesen Bereichen im Hinblick auf sein Potential abgeschirmt. Der Kontaktbereich kann eine rechteckige Form besitzen oder ringförmig ausgebildet sein.

Die Guardringe können beispielsweise durch tief reichende implantierte Strukturen ausgebildet sein, beispielsweise durch Wannenstrukturen.

Im weiteren Fertigungsverfahren können auch Standard-CMOS-Fertigungsprozesse genutzt werden. Der "wafer thinning-Prozess" kann ebenfalls auf verschiedene Art gelöst werden.

Den im Folgenden beschriebenen Ausführungsbeispiel ist das Substrat aus einem schwach dotierten n-Material ausgebildet, das beispielsweise im Zonenziehverfahren gewonnen wurde. Die Guardringe werden durch n-dotierte Wannen ausgebildet. Der Bereich außerhalb des Bereiches innerhalb der Guardringe liege auf dem Potential 0 (Erde / ground). Es wird eine Sperrspannung angelegt, so dass der Guardring mit einer positiven Vorspannung versehen ist. Dadurch wird eine Verarmungszone innerhalb des Substrates erzeugt. Der Kontaktbereich wiederum wird auf ein negatives Potential gelegt. Durch die Barriere, die durch die positive Vorspannung des Guardrings erzeugt wird, entsteht praktisch kein Leckstrom zwischen den beiden unterschiedlich dotierten Bereichen im Substrat. Andererseits ist das Substrat selbst nur schwach dotiert, so dass nur eine sehr kleine Potentialbarriere hinsichtlich des rückseitigen pn-Übergangs übersteht. Dementsprechend können Majoritätsladungsträger der Bias-Schicht, also Löcher, zum Minuspol, der an den Kontaktbereich angelegt ist, fließen. Dementsprechend beeinflusst also die negative Vorspannung des Kontaktbereichs ebenfalls die Bias-Schicht. Es entsteht praktisch ein "virtueller" Rückseitenkontakt.

Grundsätzlich kann diese Wirkungsweise im Halbleitermaterial auch dann unverändert bleiben, wenn durch Absorption von Photonen eine Ladungsträgertrennung erfolgt, das heißt, Minoritätsladungsträger entstehen. Außerhalb des entsprechenden Leitungskanals fließen die Löcher nämlich eher in Richtung Rückseite, da dieses auf einem negativen Potential liegt im Vergleich zum restlichen Substrat. Dadurch wiederum wird das Potential an der Rückseite der Halbleiterstruktur erhöht, nämlich von negativ gegen Null, was wiederum die Barriere in Bezug auf den Übergang zwischen der Bias-Schicht und dem Kontaktbereich erniedrigt. Schließlich wird ein dynamisches Gleichgewicht hergestellt, so dass die Rückseite auf einem im Wesentlichen konstanten Potential bleibt.

Durch negatives Potential an der Rückseite, nämlich an der Bias-Schicht, werden insbesondere Löcher angezogen bzw. aus dem Substrat entfernt. Zudem wird das elektrische Feld im Bezug auf das Bulkmaterial erhöht, so dass die Flusszeit der Elektronen wesentlich verkleinert werden kann. Somit kann eine entsprechende erfindungsgemäße Halbleiterstruktur auch für Anwendungen benutzt werden, bei denen es besonders auf Zeitkorrelationen ankommt, das heißt auf solche Anwendungen, bei denen die Detektion möglichst nahe an der Photonenabsorption liegen muss.

### Ausführungsbeispiele

Ausführungsbeispiele der Erfindung sind in den Zeichnungen dargestellt und werden im Folgenden unter Angabe weiterer Vorteile und Einzelheiten näher erläutert. Im Einzelnen zeigen:
- Figur 1: Eine schematische Darstellung eines Querschnitts durch eine Typographie eines Photodetektors gemäß der Erfindung,
- Figur 2: eine schematische Darstellung eines Querschnitts durch eine Typographie eines Photodetektors gemäß der Erfindung (mit schematischem Ersatzschaltbild),
- Figur 3: eine schematische Darstellung eines Querschnitts durch eine Typographie eines Photodetektors gemäß der Erfindung mit p-Wanne umfassenden Kontaktbereich,
- Figur 4: eine schematische Darstellung eines Querschnitts durch eine weitere Typographie eines Photodetektors gemäß der Erfindung,
- Figur 5: eine weitere schematische Darstellung eines Querschnitts durch eine Typographie eines Photodetektors gemäß der Erfindung (vgl. Figur 3),
- Figur 6: eine schematische Darstellung eines Querschnitts durch eine Typographie eines Photodetektors gemäß der Erfindung (vgl. Figur 3, 4) mit schematischem Ersatzschaltbild
- Figur 7: eine schematische Darstellung der Anordnung eines Kontaktbereichs auf einem Substrat,
- Figur 8: eine schematische Darstellung der Anordnung mehrerer Kontaktbereichs auf einem Substrat,
- Figur 9: eine schematische Darstellung eines ringförmigen Kontaktbereichs auf einem Substrat.

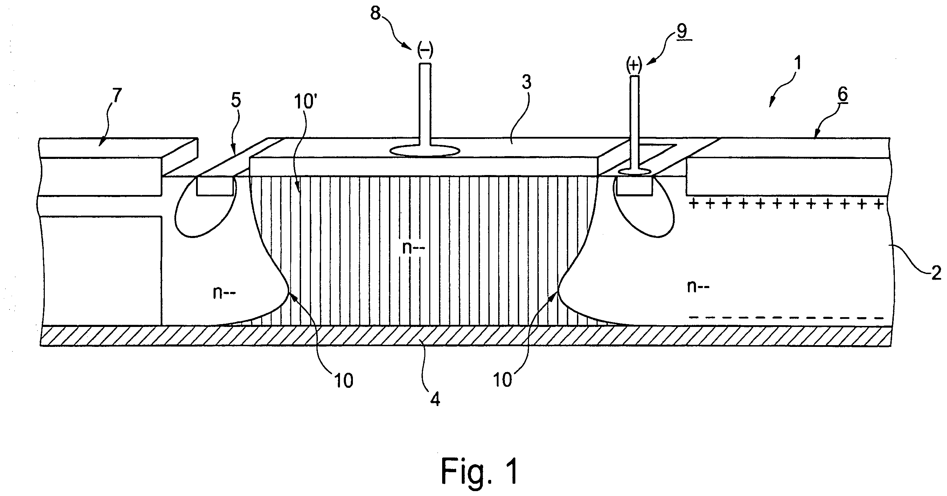

Figur 1 zeigt einen schematischen Schnitt durch eine Halbleiterstruktur 1. Diese umfasst ein Substrat 2, auf das ein Kontaktbereich 3 aufgebracht ist. Auf der Rückseite des Substrats befindet sich eine Bias-Schicht 4. Um den Kontakt 3 wiederum ist ein Guardring 5 angeordnet. Lateral versetzt zum Kontaktbereich 3 befindet sich ein CCD-Sensor 6 sowie ein weiterer CMOS-Bereich 7. An die Halbleiterstruktur 1 ist eine Sperrspannung angelegt, indem der Kontakt 3 mit dem Minuspol 8 verbunden wird, während der Guardring 5 mit dem Pluspol 9 verbunden ist. Mit welcher Polung die Sperrspannung letztendlich angelegt wird, hängt unter anderem von der Dotierung der Halbleiterstrukturen ab. Das Substrat 2 ist schwach n-dotiert. Es besteht aus im Zonenziehverfahren gewonnenem Silizium.

Der Guardring wiederum besteht aus einem n-dotieren Material, welches stärker als das Substrat dotiert ist. Die Bias-Schicht wiederum auf der Rückseite ist p-dotiert. Bei Anlegen einer Sperrspannung in der oben genannten Art und Weise bildet sich eine Verarmungszone im Substrat aus.

Dadurch, dass die Lateralausdehnung des Kontaktbereichs größer als ein Viertel der Substratdicke beträgt, kann das am Kontaktbereich anliegende Potential das Potential der Bias-Schicht beeinflussen. Es entsteht eine Art Leitungskanal, dessen Verlauf durch die Konturen 10 angedeutet ist. Durch das Anlegen des Minuspols am Kontaktbereich wandern die Löcher, welche zum Beispiel aus der p-dotierten Bias-Schicht 4 bzw. aus der durch Photonenabsorption hervorgerufenen Ladungsträgerabspaltung stammen, in Richtung Minuspol. Die Halbleiterstruktur ist ferner so ausgebildet, dass der pn-Übergang vom Substrat zur Bias-Schicht eine relativ niedrige Barriere besitzt, so dass auch hier die Löcher in Richtung Minuspol wandern können. Da an den n-dotierten Guardring der Pluspol angelegt ist, werden die Majoritätsladungsträger, die Elektronen vom Pluspol abgesaugt. Der Guardring wiederum schirmt den Kontaktbereich 3 vom CCD-Bereich 6 bzw. dem CMOS-Bereich 7 ab. Gelangt nun ein Photon bei rückseitiger Bestrahlung in den Photodetektor 1, so kann es im Bereich der Verarmungszone im Substrat 2 absorbiert werden und ein Elektron-Loch-Paar aufspalten, wobei das Loch durch den Leitungskanal 10' abgesogen werden kann und das Elektron zur Signaldetektion zur Verfügung steht.

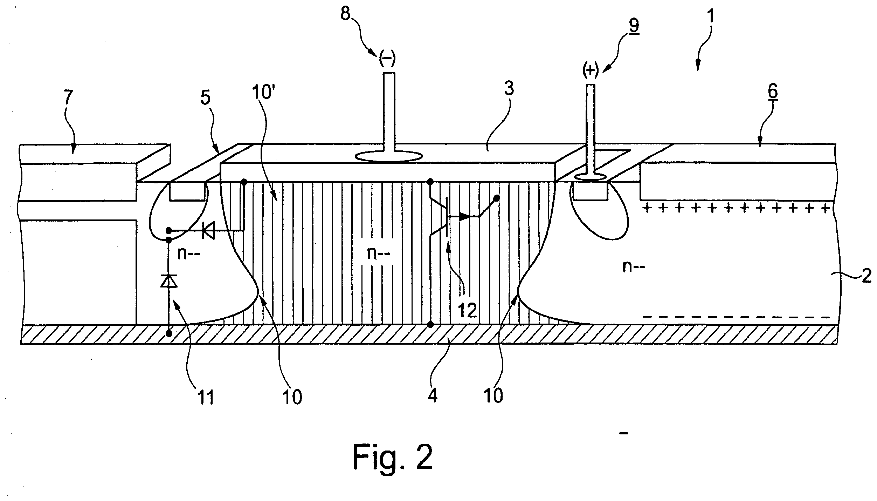

Figur 2 zeigt eine entsprechende Darstellung ähnlich zu Figur 1 mit einer Art schematischem Ersatzschaltbild, lediglich zum Verständnis: Der Aufbau kann in ähnlicher Weise mit einer Diodenschaltung 11 bzw. mit einer Transistorschaltung 12 verglichen werden.

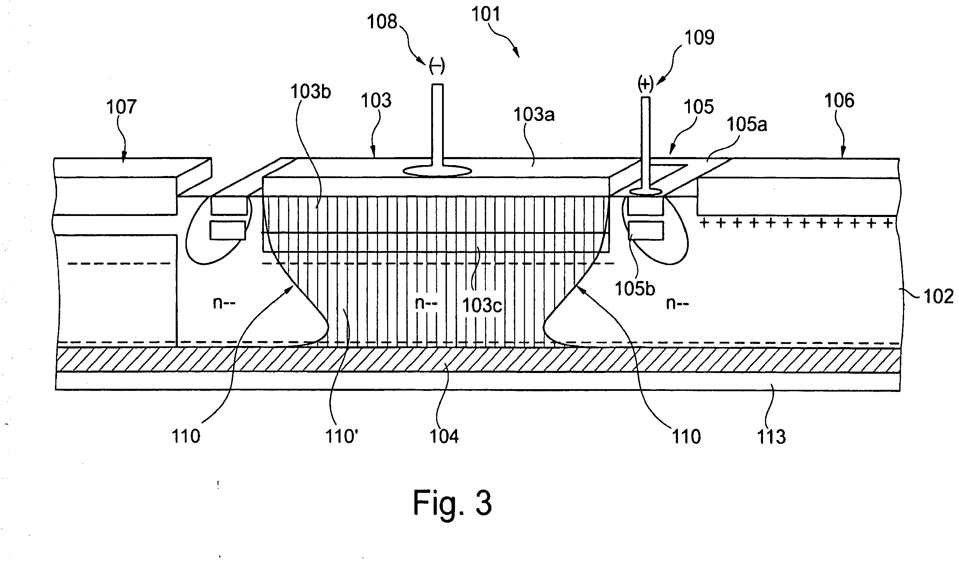

Figur 3 zeigt einen ähnlichen Aufbau, bei dem der Kontaktbereich 103 jedoch aus einem metallischen Kontakt 103a besteht, der auf das Substrat 102 aufgebracht ist, sowie ferner aus einer hochdotierten p-Wanne 103b und einer darunter befindlichen ebenfalls stark dotierten (p+)-Schicht 103c. Das Substrat 102 besteht aus schwach n-dotiertem, im Zonenziehverfahren gewonnenem n-Material. Der Guardring 105 wiederum umfasst eine stark n-dotierte Schicht 105a und eine darunter befindliche weitere vergrabene n-dotierte Schicht 105b. Die Bias-Schicht auf der Rückseite ist stark p-dotiert (Bezugszeichen 104). Auf ihr ist wiederum eine Passivierung 113 aufgebracht, welche der Versiegelung der Oberfläche dient. Denkbar ist beispielsweise die Verwendung eines Silikatglases zur Passivierung.

Durch Anlegen des Minuspols 108 am Kontaktbereich 103 werden die dort befindlichen Löcher, die Majoritätsladungsträger des p-Wannenmaterials, abgesogen. Analoges, nämlich die Absaugung von Elektronen geschieht durch Anlegen des Pluspols 109 am Guardring 105. Durch die breite laterale Ausdehnung des Kontaktbereichs 103 im Vergleich zur Distanz zwischen dem Kontaktbereich 103 und der Bias-Schicht 104 bildet sich ein Leitungskanal 110' aus, der durch die Linien 110 jeweils angedeutet wird. Ferner befinden sich ebenfalls, lateral versetzt vom Kontaktbereich 103 eine CCD-Elektronik 106 sowie weitere CMOS-Bereiche 107.

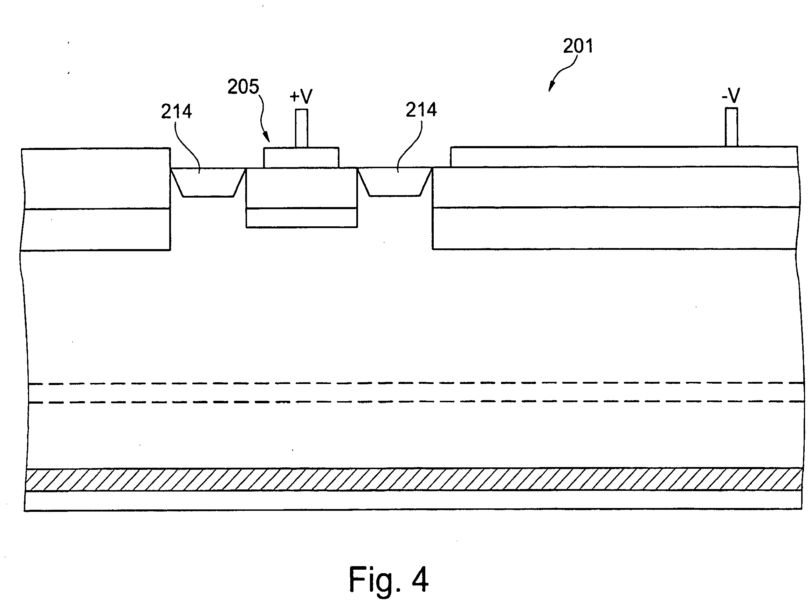

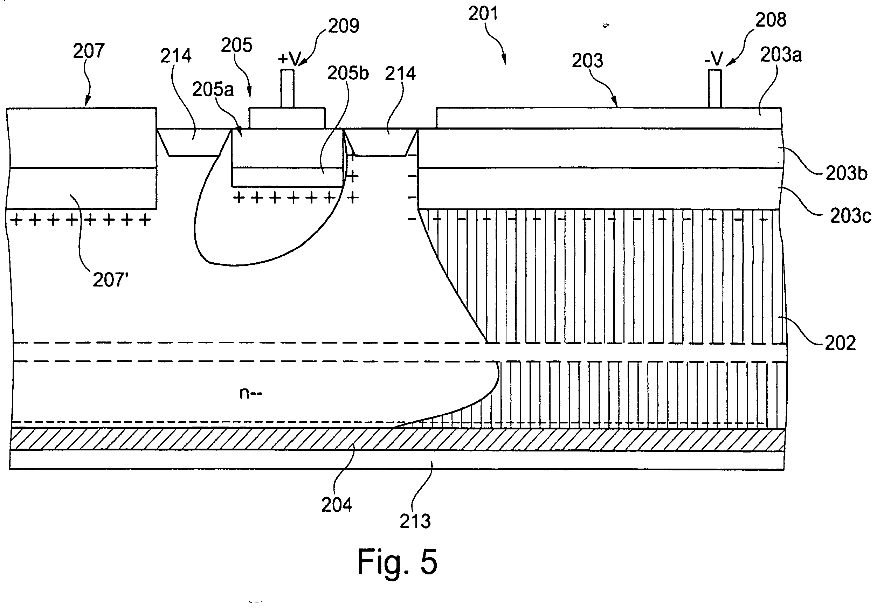

Eine weitere Struktur eines entsprechenden Photodetektors 201 ist in den Figuren 4 bis 6 dargestellt. Dieser umfasst ebenfalls einen Kontaktbereich 203 mit einem metallischen Kontakt 203a einer darunter befindlichen stark dotieren p-Wanne 203b und einer darunter befindlichen weiteren p-dotierten Schicht 203c.

Das eigentliche Substrat 202 wiederum ist schwach n-dotiert. Der Kontaktbereich 203 wird umgeben von einem Guardring 205. Dieser umfasst eine metallische Kontaktierung sowie eine stark n-dotierte Wanne 205a und eine weitere n-dotierte Schicht 205b, welche unter der Wanne liegt. Ferner ist eine Bias-Schicht 204, die stark p-dotiert ist, auf der Rückseite aufgebracht, sowie eine Passivierungsschicht 213. Eine entsprechende CMOS-Struktur 207 mit einer darunter befindlichen, ebenfalls abschirmenden, p-dotierten Schicht 207' ist ebenso vorhanden. Im Unterschied zu den vorherigen Strukturen ist insbesondere der Guardring von einer Grabenisolation 214 (engl.: shallow-trench isolation, STI) innen (also zum Kontaktbereich hin) und außen (das heißt zu den weiteren Bereichen wie zum Beispiel im CMOS-Bereich hin) umgeben. Diese STI-Struktur dient der stärkeren Abgrenzung der einzelnen Bereiche. Die Kontaktierung der Struktur erfolgt in gewohnter Weise, das heißt der Minuspol 208 wird an dem Kontaktbereich 203 angelegt, während der Pluspol 209 an den Guardring 205 angelegt wird.

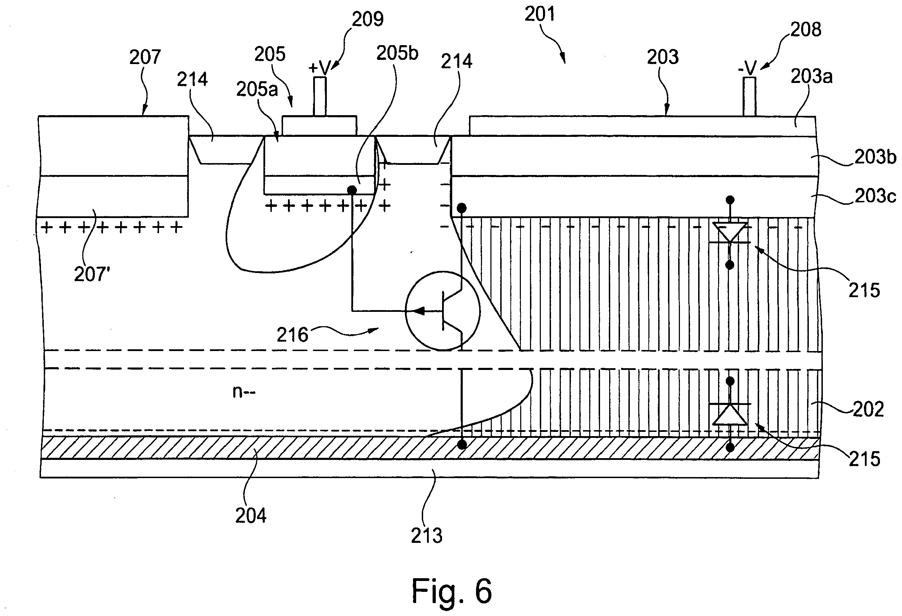

In Figur 6 sind lediglich zur besseren Erläuterung schematische Ersatzschaltbilder 215 und 216 eingefügt. Die gegeneinander geschalteten Dioden 215 verdeutlichen entsprechend die Ausbildung einer Verarmungszone.

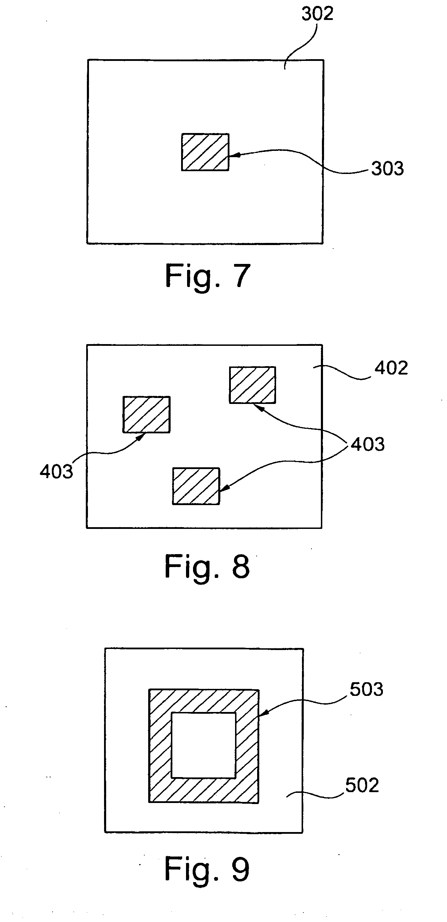

Weiterhin sind in den Figuren 7, 8 und 9 Beispiele dargestellt, wie Kontaktbereiche 303, 403, 503 angeordnet und hinsichtlich ihrer Form ausgebildet sein können. Figur 7 zeigt ein Substrat 302 einer Halbleiterstruktur in Draufsicht mit einem an der Vorderseite angebrachten einzelnen und punktförmig ausgebildeten Kontaktbereich 303. Figur 8 wiederum zeigt mehrere punktförmige Kontatktbereiche 403 auf einem Substrat 402. Figur 9 zeigt einen ringförmigen Kontaktbereich 503 auf einem Substrat 502.

Zusammenfassend ist eine besonders bevorzugte Halbleiterstruktur zur Photonendetektion ist folgendermaßen aufgebaut:
Sie besitzt ein hochohmiges Substrat, welches aus im Zonenziehverfahren gewonnenem Silizium (Engl.: float-zone silicon) gefertigt ist mit einem spezifischen Widerstand p > 2000 Ω cm. Dieses halbintrinsische Halbleitermaterial ist z.B. dementsprechend (n--)-dotiert. Dieses Substrat wird auf eine Dicke von ca. 50 µm abgedünnt.

Zudem weist der Halbleiter einen Kontaktbereich an der Vorderseite des Substrats auf. Insbesondere kommt ein Format von 50 um x 200 um in Betracht. Wird, wie vorliegend, ein schwach n-dotiertes Substrat gewählt, umfasst der Kontaktbereich ein sog. p-Source/drain-Implantation aus einem (p++)-dotierten Material (spezifischer Flächenwiderstand ca. 100 Ω bzw. 100 Ω /sq., angeordnet im Bereich von 0 nm bis ca. 100 nm), zudem eine p-Wannen-Implantation mit einer (p+)-dotierten Schicht (spezifischer Flächenwiderstand: ca. 1000 Ω /sq., angeordnet im Bereich von ca. 0,1 µm bis 1,0 µm Tiefe). Diese p-Wanne ist so ausgelegt, dass ein Potential von -1 V bis -5 V angelegt werden kann. Außerdem ist eine p-Subimplantiation vorgesehen, welche aus einem (p+)-dotierten Bereich (spezifischer Flächenwiderstand von ca. 1000 Ω /sq., angeordnet in einer Tiefe von ca. 0,7 um bis 1,5 µm).

Der Guardring ist ebenfalls auf der Vorderseite des Substrats ausgebildet und umgibt desn Kontaktbereich. Die Breite des Guardrings beträgt vorzugsweise ca. 10 um, die Distanz zum Kontaktbereich ebenfalls ca. 10 um. Ferner ist vorzugsweise eine Grabenisolation (STI) mit einer Breite von 10µm innerhalb und außerhalb des Guardrings vorgesehen. Der Guardring umfasst entsprechend eine n-Source/Drain-Implantation aus (n++)-dotiertem Material mit einem spezifischen Flächenwiderstand von weniger als 100 Ω /sq. und einer Tiefe von der Oberfläche an von 100 nm. Zudem umfasst die Guardring-Struktur eine n-Wannen-Implantation aus (n+)-dotiertem Material (spezifischer Flächenwiderstand: ca. 800 Ω /sq., Tiefe ca. 0,7 um bis 1,5 µm, angeorndet im Bereich von 100 nm bis 1000 nm Tiefe). Die n-Wannen-Implantation ist so ausgebildet, dass eine Isolierspannung von +5 V bis +10 V angelegt werden kann. Ferner ist eine als vergrabenen n-Schicht ausgebildete Implantation (engl.: n-buried layer implant) aus einem (n+)-dotierten Material (spezifischer Flächenwiderstand: ca. 1300 Ω /sq., vorgesehen, Tiefe: ca. 0,5 µm bis 1,0 µm), welche im Bereich von 500 nm bis 700 nm Tiefe liegt). Darunter ist keine weitere Schicht vorgesehen, insbesondere keine direkte Kontaktierung des n-Guardrings mit dem Substrat.

Weiterhin ist eine Schicht auf der Rückseite (engl.: backside layer) vorgesehen, die vom Kontaktbereich beabstandet ist, jedoch einen lateralen Überlapp mit dem Kontaktbereich bildet. Sie umfasst eine p-Wannen-Implantation ((p+)-dotiert mit einem spezifischen Flächenwiderstand von weniger als 1000 Ω /sq.), welche von der rückseitigen Oberfläche 200 nm tief reicht. An der Oberfläche ist diese Schicht (backside layer) von einer Antireflexschicht (engl.: Anti-reflective coating, ARC layer) aus Nitriden, ZbSiO oder ZbSiNi) bedeckt. Die rückseitige Schicht ist regelmäßig homogen ausgebildet, d.h. ohne Strukturierung und reicht über den gesamten Waferbereich, gegebenenfalls abgesehen von einem schmalen Randbereich, der z.B. nicht abgedünnt und auf der Rückseite bestückt ist.

### Bezugszeichenliste:

- 1: Photodetektor
- 2: Substrat
- 3: Kontakt
- 4: Bias-Schicht
- 5: Guardring
- 6: CCD-Bereich
- 7: CMOS-Bereich
- 8: Minuspol
- 9: Pluspol
- 10: Potentiallinien
- 10': Leitungskanal
- 11: Dioden-Ersatzschaltbild
- 12: Transistor-Ersatzschaltbild
- 101: Photodetektor
- 102: Substrat
- 103: Kontaktbereich
- 103a: Metallkontakt
- 103b: p-Wanne
- 103c: (p+)-Schicht
- 104: Bias-Schicht
- 105: Guardring
- 105a: (n+)-Wanne
- 105b: (n+)-Schicht
- 106: CCD-Bereich
- 107: CMOS-Bereich
- 108: Minuspol
- 109: Pluspol
- 110: Potentiallinie
- 100': Leitungskanal
- 113: Passivierung
- 201: Photodetektor
- 202: Substrat
- 203: Kontaktbereich
- 203a: Metallkontakt
- 203b: p-Wanne
- 203c: p-Schicht
- 204: Bias-Schicht
- 205: Guardring
- 205a: (n+)-Wanne
- 205b: (n+)-Schicht
- 207: CMOS-Bereich
- 207': p-Schicht
- 208: Minuspol
- 209: Pluspol
- 213: Passivierung
- 214: Grabenisolation
- 215: Dioden-Ersatzschaltbild
- 216: Transistor-Ersatzschaltbild
- 302: Substrat
- 303: Kontaktbereich
- 402: Substrat
- 403: Kontaktbereich
- 502: Substrat
- 503: Kontaktbereich

## Patentansprüche

1. Halbleiterstruktur (1, 101, 201) zur Photonendetektion, wobei die Halbleiterstruktur dazu ausgebildet ist, von der Rückseite beleuchtet zu werden,
umfassend:
- ein Substrat (2, 102, 202, 302, 402, 502) aus einem Halbleitermaterial mit einer Dotierung erster Art,
- einen Kontaktbereich (3, 103, 203, 303, 403, 503), der an der Vorderseite des Substrates angebracht ist,
- eine Bias-Schicht (4, 104, 204) aus einem Halbleitermaterial mit einer zweiten Dotierung, welche auf der Rückseite des Substrats beabstandet vom Kontaktbereich angeordnet ist, wobei der Kontaktbereich wenigstens teilweise der Bias-Schicht gegenüber liegt, so dass in lateraler Richtung ein Überlappbereich vorhanden ist,
- ein Guardring (5, 105, 205), der an der Vorderseite des Substrats angeordnet ist und den Kontaktbereich umgibt, wobei zwischen dem Kontaktbereich und dem Guardring eine Sperrspannung anlegbar ist,
wobei
der Überlappbereich eine laterale Ausdehnung aufweist, die wenigstens ein Viertel der Distanz zwischen Kontaktbereich und Bias-Schicht beträgt, und der Kontaktbereich dazu ausgebildet ist, durch das an ihn angelegte Potential das Potential der Bias-Schicht zu beeinflussen und somit einen Leitungskanal zwischen dem Kontaktbereich und der Bias-Schicht auszubilden, ohne dass eine Kontaktierung der Bias-Schicht vorliegt, **dadurch gekennzeichnet, dass** die Bias-Schicht im Vergleich zum Substrat ungleichnamig dotiert ist und der Guardring eine gleichnamige Dotierung aufweist wie das Substrat.

2. Halbleiterstruktur nach Anspruch 1, **dadurch gekennzeichnet, dass** der Kontaktbereich als auf das Substrat aufgebrachter Metallkontakt ausgebildet ist.

3. Halbleiterstruktur nach einem der vorgenannten Ansprüche, **dadurch gekennzeichnet, dass** der Kontaktbereich eine im Substrat ausgebildete Wanne (103b, 203b) umfasst, welche ungleichnamig zur Dotierung erster Art dotiert ist.

4. Halbleiterstruktur nach einem der vorgenannten Ansprüche, **dadurch gekennzeichnet, dass** das Substrat hochohmig mit einem spezifischen Widerstand ρ > 2000 Ω cm, insbesondere schwach dotiert ist.

5. Halbleiterstruktur nach einem der vorgenannten Ansprüche, **dadurch gekennzeichnet, dass** der Guardring stärker dotiert ist als das Substrat.

## Claims

1. A semiconductor structure (1, 101, 201) for photon detection, the semiconductor structure being designed to be illuminated from the rear side, comprising:
- a substrate (2, 102, 202, 302, 402, 502) made of a semiconductor material with a first-type doping,
- a contact area (3, 103, 203, 303, 403, 503) which is attached to the front side of the substrate,
- a bias layer (4, 104, 204) made of a semiconductor material with a second doping, which is arranged on the rear side of the substrate at a distance from the contact area, the contact area being at least partially opposite the bias layer so that an overlap area in the lateral direction is provided,
- a guard ring (5, 105, 205), which is arranged on the front side of the substrate and surrounds the contact area, it being possible to apply a blocking voltage between the contact area and the guard ring,
wherein
the overlap area has a lateral extent that is at least a quarter of the distance between the contact area and the bias layer, and the contact area is designed, through the potential applied to it, to influence the potential of the bias layer and thus to form a conduction channel between the contact area and the bias layer without there being any contact with the bias layer, **characterised in that** the bias layer has a doping of opposite sign to the substrate and the guard ring has a doping of the same sign as the substrate.

2. The semiconductor structure according to claim 1, **characterised in that** the contact area is formed as a metal contact applied to the substrate.

3. The semiconductor structure according to one of the preceding claims, **characterised in that** the contact area comprises a well (103b, 203b) formed in the substrate, which well has a doping of opposite sign to the first-type doping.

4. The semiconductor structure according to one of the preceding claims, **characterised in that** the substrate is of high resistance with a specific resistance ρ > 2000 Ω cm, in particular is weakly doped.

5. The semiconductor structure according to one of the preceding claims, **characterised in that** the guard ring is more heavily doped than the substrate.

## Revendications

1. Structure semi-conductrice (1, 101, 201) pour la détection de photons, la structure semi-conductrice étant conçue pour être éclairée par l'arrière, comprenant :
- un substrat (2, 102, 202, 302, 402, 502) en un matériau semi-conducteur avec un dopage d'un premier type,
- une zone de contact (3, 103, 203, 303, 403, 503) qui est fixée à l'avant du substrat,
- une couche (4, 104, 204) placée en amont (bias layer) en un matériau semi-conducteur avec un second dopage, qui est disposée à l'arrière du substrat à distance de la zone de contact, la zone de contact étant au moins partiellement opposée à la couche placée en amont, de sorte qu'une zone de chevauchement est présente dans la direction latérale,
- un anneau de garde (5, 105, 205), qui est disposé à l'avant du substrat et entoure la zone de contact, une tension de blocage pouvant être appliquée entre la zone de contact et l'anneau de garde,
dans laquelle
la zone de chevauchement présente une étendue latérale qui représente au moins un quart de la distance entre la zone de contact et la couche placée en amont, et la zone de contact est conçue pour influencer le potentiel de la couche placée en amont par le potentiel qui lui est appliqué, et de cette manière, un canal de conduction est formé entre la zone de contact et la couche placée en amont sans contact avec la couche placée en amont, **caractérisée en ce que** la couche placée en amont a un dopage de signe opposé par rapport au substrat et l'anneau de garde présente un dopage du même signe que le substrat.

2. Structure semi-conductrice selon la revendication 1, **caractérisée en ce que** la zone de contact est conçue comme un contact métallique appliqué sur le substrat.

3. Structure semi-conductrice selon l'une quelconque des revendications précédentes, **caractérisée en ce que** la zone de contact comprend une cuvette (103b, 203b) formée dans le substrat, la cuvette ayant un dopage de signe opposé par rapport au dopage du premier type.

4. Structure semi-conductrice selon l'une quelconque des revendications précédentes, **caractérisée en ce que** le substrat est hautement résistif avec une résistance spécifique ρ > 2000 Ω cm, notamment faiblement dopé.

5. Structure semi-conductrice selon l'une quelconque des revendications précédentes, **caractérisée en ce que** l'anneau de garde est plus fortement dopé que le substrat.
